# EUROPEAN PATENT APPLICATION

(11) **EP 1 703 556 A1**
(43) Date of publication of application: **20.09.2006**
(21) Application number: 05719051.4
(22) Date of filing: 07.01.2005
(51) Int. Cl.: H01L 23/367

(54) **HEAT SINK**

(30) Priority: 07.01.2004 JP 2004002521
(71) Applicant: Jisouken Co. Ltd., Tokyo 105-0001 (JP)
(72) Inventor: HONMA, Mitsuo, 2790026 (JP)
(74) Representative: Rees, Alexander Ellison
(86) International application number: PCT/JP2005/000120
(87) International publication number: WO 2005/067036

(57) **Abstract**

The present invention seeks to provide a novel heat sink capable of being effectively produced at a low cost and having excellent heat dissipation performance. The heat sink comprises fins 11 of a metal wire coil formed of coil elements 11a and 11b made by winding a flat metal wire. The fins 11 are disposed on a heat conductive base plate 10 with flat surfaces 111 of the fins arranged perpendicular to the base plate 10.

## Description

### TECHNICAL FIELD

This invention relates to a heat sink, and more specific, belongs to a technical field of the heat sink, which is mounted primarily on a semiconductor device to have flowing gas or liquid absorb heat generated within the semiconductor device, thereby to cool the semiconductor device or used as a heat exchange element for many applications.

### BACKGROUND OF THE ART

Quantity of heat generated by a semiconductor device has been increasing with improvement of performance of the semiconductor device. The rise in temperature of the semiconductor device deteriorates the performance of the device. When a junction of the semiconductor is kept in a high temperature state, the semiconductor shortens its life by heat, and in the worst case, may possibly break. Such being the case, there has been used a heat sink for cooling the heat within the semiconductor device such as a CPU of a computer by diffusing the heat into cold air.

A conventional heat sink improved the heat dissipation performance thereof by devising its surface shape so as to increase the surface area of the heat sink for effectively cooling the semiconductor device.

For instance, Patent Literature #1 discloses a heat sink comprising a base plate with pores, on which pole fins with pores are planted.
The conventional heat sink has pores to increase the surface area for increasing the heat dissipation performance, but it was made by a die casting method or a drawing method, thus consuming much time and labor and leading to high cost of production.

Meanwhile, Patent Literature #2 discloses a semiconductor device comprising a package encapsulating a semiconductor element and lead wires electrically connected to the semiconductor element, a metal plate formed on the package, and a coil type radiating member made of thin metallic wire, which is mounted on the metal plate. The metal wire coil serving as a radiating fin has the advantage of being able to be produced at a low cost.

However, the radiating member disclosed in the Patent Literature #2 suffers from the disadvantage of low thermal conductivity, resulting in degrading the heat dissipation performance, because the coil and the metal plate are in point contact with each other. Besides, the coil, which is large in size, cannot be formed compactly on the metal plate, as the result of which sufficient heat dissipation performance cannot be obtained disadvantageously.

(Patent Literature #1) Japanese Patent Application Publication HEI 08-330483(A)
(Patent Literature #2) Japanese Patent Application Publication HEI 06-275746(A)

### DISCLOSURE OF THE INVENTION

### PROBLEMS TO BE RESOLVED BY THE INVENTION

In the light of the conventional situation, the present invention seeks to provide a novel heat sink having excellent heat dissipation performance, which can be produced effectively at a low cost.

### MEANS OF SOLVING THE PROBLEMS

To attain the object as mentioned above according to the present invention, there is provided a heat sink comprising fins formed by winding metal wire into a coil shape having coil elements, which are aligned in flat as a whole with displacement so as to form air gaps and contact parts, and a thermal conductive base plate retaining the aforesaid fins.

According to the structure of the invention described above, the heat sink having a large surface area can easily be made, using the metal wire coil. The coil elements of the metal wire coil are in mutual contact with one another facilitate heat transfer by conduction and form many air gaps to let air through, thus to improve the heat dissipation performance. The coil shape into which the metal wire is wound is not limited to a circular form and may be a triangular, quadrangular or polygon shape, an elliptical shape, a star shape or any other shapes. The thermal conductive base plate in this invention includes a base plate or substrate of the semiconductor device requiring heat release.

The heat sink of the invention is further featured by thermal coupling between the contact parts of the coils.

The thermal coupling between the contact parts according to the characteristic structure of the invention permits smooth heat transfer by conduction to throughout the fins. The thermal coupling defined herein means fixation of the contact parts without detriment to the heat dissipation performance at the contact parts, which is effected by a joining method such as soldering, solder plating, flash butt welding, or vibration welding, or an adhesive joining method using adhesive agent or agglutinant.

Further, the present invention is featured in that, in any of the heat sinks described above, the metal wire coil is formed of combinations of right-handed and left-handed coils, which are displaced mutually.

According to the structure described above, the metal wires are densely formed to improve the thermal conductivity and heat dissipation performance of the heat sink. Furthermore, since the right-handed and left-handed coils intertwine with one another, the coil is stably formed.

Further, the present invention is featured in that, in any of the heat sinks described above, the fins are disposed relative to the base plate in a standing manner.

According to the structure mentioned above, the fins standing on the base plate effectively increases the surface area of the heat sink and allows passage of air through the air gaps formed in the coil elements. Further, the metal wires of the coil at the flattened surface end parts (the contact parts between the fins and base plate) are densely formed with high density, thus to decrease thermal resistance caused in conducting the heat along the base plate.

Further, the present invention is featured in that, in any of the heat sinks described above, the fins are disposed in a groove formed in the base plate in a standing manner.

The structure mentioned above brings about effect of steadily securing the fins on the base plate and effectively increasing the contact area between the fins and base plate, thereby to facilitate heat conduction between the fins and base plate.

Further, the heat sink of the invention is featured by thermally coupling the fins to the groove in the base plate.

The structure mentioned above brings about effect of making the heat conduction between the fins and the base plate, which is in thermal contact with the fins at the contact parts, thus to expedite heat conduction throughout the fins. The thermal coupling defined herein means fixation of the contact parts without detriment to the heat dissipation performance at the contact parts, which is effected by a joining method such as soldering, solder plating, flash butt welding, or vibration welding, or an adhesive joining method using adhesive agent or agglutinant.

Further, the heat sink of the invention is featured by arranging the flat surfaces of the fins parallel to the thermal conductive base plate.

The structure mentioned above materializes a thin heat sink having a large surface area. The coil shape into which the metal wire is wound is not limited to a circular form and may be a triangular, quadrangular or polygon shape, an elliptical shape, a star shape or any other shapes.

Further, the heat sink of the invention is featured by forming void spaces between the fins and the base plate and filling the aforesaid void spaces with ferrite powder.

The structure mentioned above can make the surface area of the entire heat sink large and absorb electromagnetic wave. The ferrite powder herein includes soft ferrite, hard ferrite and their mixture.

Further, the heat sink of the invention is featured by the fins of the metal wire coil formed of the coil elements made by densely winding a flat metal wire.

The structure mentioned above enables the fins to be formed directly on a desirable surface to be cooled. The coil shape into which the metal wire is wound is not limited to a circular form and may be a triangular, quadrangular or polygon shape, an elliptical shape, a star shape or any other shapes.

Further, the present invention provides a sheet-like heat sink comprising a base film with agglutinant, and fins of the metal wire coil formed of the coil elements made by densely winding a flat metal wire on the base film. The coil shape into which the metal wire is wound is not limited to a circular form and may be a triangular, quadrangular or polygon shape, an elliptical shape, a star shape or any other shapes.

The structure mentioned above can form the heat sink like an adhesive sheet (a strip when making the heat sink long) in an adhesive manner directly to a desirable surface to be cooled.

Further, the present invention is featured in that, in any of the heat sinks described above, a coating film containing ferrite is formed on the surface of the metal wire.

The structure mentioned above can make the surface area of the entire heat sink large and absorb electromagnetic wave. The ferrite herein includes soft ferrite, hard ferrite and their mixture.

Further, the present invention is featured in that, in any of the heat sinks described above, the metal wire is made of aluminum or aluminum alloy and subjected to surface treatment with anodic oxide film.

According to the structure of the invention described above, the metal wire can be made of a low-cost material having high thermal conductivity. Besides, the surface-treated metal wire excels in corrosion resistance.

Further, the present invention is featured in that, in any of the heat sinks described above, the metal wire is made of anticorrosion metal.

The structure mentioned above materializes a heat sink suitable for use in corrosive gas environment. The anticorrosion metal herein means metal impervious to acids and alkalis, and in particular, includes titanium, titanium alloy, and stainless steel.

Further, the present invention is featured in that, in any of the heat sinks described above, a heat-dissipative coating film having heat dissipation capacity is formed on the surface of the metal wire.

The fins in the structure above further increase the heat dissipation capacity of the heat sink. The heat-dissipative coating film herein means a coating formed of coating material containing pigment having a thermal radiation effect such as carbon black.

### EFFECT OF THE INVENTION

The metal wire coil of the heat sink according to the invention eliminates a complicated process such as a cutting work that is conventionally required and has a large surface area to increase the heat dissipation performance of the heat sink. Consequently, the heat sink having high heat dissipation performance can be produced at a low cost.

Especially, the coil elements of the metal wire coil are in mutual contact with one another facilitate heat transfer by conduction and form many air gaps to let air through, thus to improve the heat dissipation performance. In the case of the heat sink using the flat fins, the fins can be disposed on the base plate with high density. Besides, the heat sink of the invention is featured by the air passages defined by the air gaps having an effect of ventilation in the fins.

### BRIEF DESCRIPTION OF THE DRAWINGS

FIG 1 is a perspective view showing a heat sink in a first embodiment (1) of the present invention.
FIG 2 shows a fin.
FIG 3 shows the fin of the heat sink in a second embodiment (2) of the present invention.
FIG 4 shows a production method for another type of fin.
FIG 5 shows a production method for still another type of fin.
FIG 6 is an enlarged view of a longitudinal section of the heat sink in the second embodiment (2) of the invention.
FIG 7 is an enlarged view showing a transverse section taken in the width direction of the heat sink in the second embodiment (2) of the invention.
FIG. 8 is an enlarged view showing a transverse section taken in the width direction of another heat sink in the second embodiment (2) of the invention.
FIG 9 is an enlarged view showing a transverse section taken in the width direction of still another heat sink in the second embodiment (2) of the invention.
FIG 10 is a perspective view showing a heat sink in a third embodiment (3) of the present invention.
FIG 11 is a perspective view showing a heat sink in a fourth embodiment (4) of the present invention.
FIG 12 is a perspective view showing a heat sink in a fifth embodiment (5) of the present invention.
FIG 13 is a perspective view showing a heat sink in another embodiment of the present invention.
FIG 14 shows one example of use of the heat sink according to the invention.
FIG 15 shows the heat sink used as a heat exchange element of the invention.
FIG 16 is a cross section taken along line C-C in FIG 15.
FIG. 17 shows another example of use of the heat sink according to the invention.
FIG 18 shows still another example of use of the heat sink according to the invention.
FIG 19 shows yet another example of use of the heat sink according to the invention.
FIG 20 shows a further example of use of the heat sink according to the invention.
FIG 21 is a cross section taken along line D-D in FIG. 20.

### EXPLANATION OF REFERENCE NUMERALS

- 1: Heat sink
- 10: Base plate
- 100: Groove
- 101: Void space
- 11: Fin
- 11a; 11b: Coil element
- 11c; 11d: End part
- 11e: Central part
- 111: Flat surface
- 112: Air gaps
- 113: Contact part
- 12,13: Metal wire
- 16: Solder
- 17: Thermal conductive adhesive agent
- 18: Ferrite powder
- 19: Semiconductor device
- 2: Air conditioning ventilation fan
- 21: Housing
- 22: Intake fan
- 23: Motor
- 24: Intake passage
- 25: Exhaust passage
- 26: Heat exchange element
- 3: Building
- 31: Wall
- 311: Inner wall
- 312: Outer wall
- 313: Space
- 314; 315: Air hole
- 32: Room
- 33: Air
- 34: Sunlight
- 4: Underfloor storage
- 40: Floor cover
- 41: Frame member
- 42: Wall member
- 51: Gas range
- 52: Ventilation equipment
- 53: Hood body
- 54: Exhaust duct
- 55: Exhaust fan
- 56: Oil mist / vapor
- 57: Pocket
- 6: Solar water heater
- 61: Hot water reservoir
- 62: Heat collecting unit
- 63: water supply pipe
- 64: Pipe
- 65: Outflow pipe
- 66: Transparent member
- 67: Heat insulating material

### BEST MODE FOR CARRYING OUT THE INVENTION

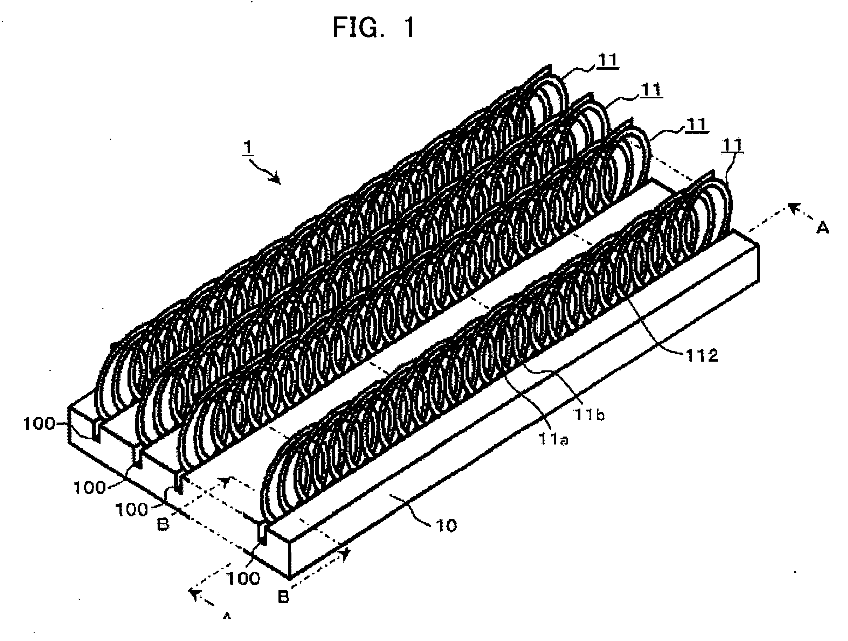

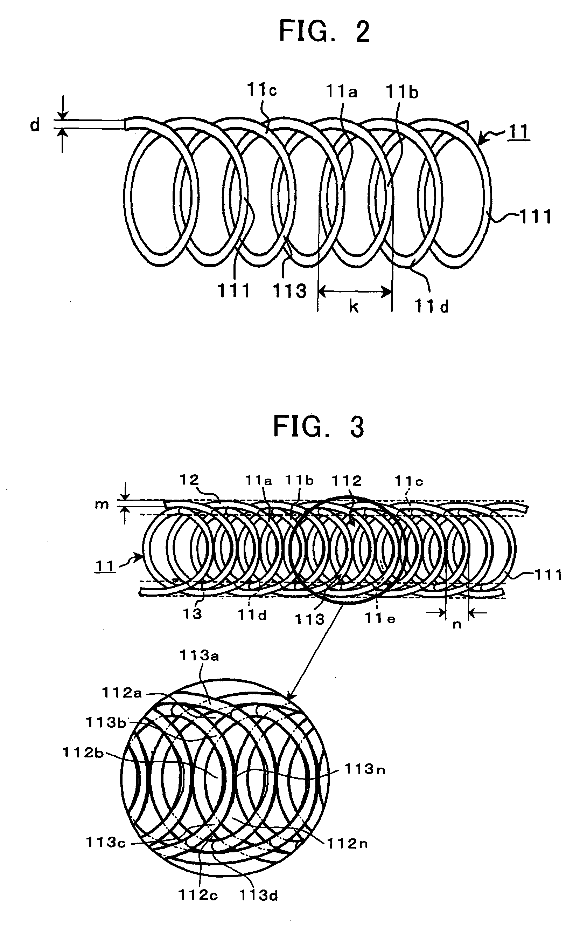

Hereinafter, the present invention will be described in detail.
First, the first embodiment (1) of the invention will be described with reference to FIGS. 1 and 2. The heat sink in FIG 1 generally comprises a base plate 10 with a plurality of grooves 100, and fins 11 formed of metal wire coil arranged along the grooves 100. In FIG 1, only one row of fins 11 is illustrated and the other rows of fins are partially abbreviated for ease of explanation.

The fins 11 are formed by flattening the metal wire coil. Adjacent coil elements 11a and 11b are in close contact with each other at contact parts 113 through which heat diffuses rapidly throughout the fins 11. Thus, the metal wire is formed in a coil so as to provide a large surface area to the fins, thus increasing the heat dissipation performance.

The fins 11 made of the metal wire coil as shown in FIG 2 have end parts 11c and 11d of the flat surface 111 to increase the density of the coil elements. Consequently, thermal resistance between the base plate 10 and fins 11 aligned on the base plate is decreased to facilitate transfer of heat.

The heat sink of FIG 1 has the fins 11 fitted in grooves 100. The fins 11 are disposed on the thermal conductive base plate 10 with the flat surfaces 111 of the fins 11 standing perpendicular to the base plate. The fins 11 has air gaps 112 for permitting passage of air therethrough, so that lots of air blown by a cooling fan can be taken into the air gaps, thus to rapidly remove the heat.

The metal wire coil may be flattened by a conventional forming method such as flatting or rolling. By continuously rolling the metal wire coil fed in one direction, a long fin 11 can be produced. It is desirable to appropriately adjust the pressure and angle of rolling so as to bring the adjacent coil elements 11a and 11b into close contact with each other. However, improper rolling may possibly spread the coil to weaken the strength of the coil. In such a case, there had better roll left-handed and right-handed coils in coaxially combination (in an intertwining state) to flatten the coils in order.

The base plate 10 may be made of materials having high thermal conductivity. To be more specific, metal such as aluminum, copper, silver and gold, an alloy of the aforesaid metal and nickel, magnesium, zinc or silicon, or carbon materials may be used for the base plate.

The groove 100 in the base plate 10 may be formed by subjecting the flat surface of the base plate to a cutting work. The groove 100 can otherwise be formed in the base plate 10 by a die casting method or an extrusion molding method. The pitch and configuration of the groove 100 may be arbitrarily determined according to the heat dissipation performance and size of the fin 11.

The fin 11 may also be made of any material similarly to the aforementioned base plate 10. To be more specific, metal such as aluminum, copper, silver and gold, an alloy of the aforesaid metal and nickel, magnesium, zinc or silicon, or carbon materials may be used for the fin. Particularly, aluminum-based materials are suitably used because they have high thermal conductivity and are inexpensive.

Anticorrosion metal may be used for the metal wire of the fin 11. The heat sink having the anticorrosion metal wire coil is suitable for use under corrosion-prone environment. As the anticorrosion metal, titanium, an alloy of titanium and stainless steel may be used suitably.

The metal wire constituting the fin 11 may be subjected to surface treatment such as copper plating and silvering to improve the thermal conductivity and corrosion resistance as circumstances demand. In a case where the metal wire is made of aluminum or its alloy, it is preferable to subject the surface of the metal wire to anodic oxide coating (alumite treatment). The surface treatment on the metal wire improves the corrosion resistance thereof, decrease the thermal resistance of the contact parts 113 at which the coil elements 11a and 11b are in close contact with each other, and increase the heat dissipation capacity of the heat sink. The surface treatment is carried out in an appropriate manner as known conventionally. For instance, the metal wire can be coated with an oxide layer by subjecting the metal wire to an anodic electrolytic treatment in electrolysis solution containing oxalic acid, sulfuric acid or phosphoric acid. Either white alumite treatment or black alumite treatment may be as the anodic electrolytic treatment.

On the surface of the metal wire, a coating film containing ferrite may be formed if required. The heat sink with the metal wire coil coated with ferrite having an electromagnetic wave absorption power can effectively absorb electromagnetic wave as a whole. Particularly, since the fin 11 made of the metal wire has an uneven surface, the electromagnetic wave reflects diffusely on the surface of the fin 11, consequently to synergistically increase the electromagnetic wave absorption power.
As the ferrite, there may be used either or a combination of soft magnetic ferrite (soft ferrite) and hard magnetic ferrite (hard ferrite), which have been generally known. A binder for dispersing the ferrite is not limited to a specific material, but common materials such as acrylate resin silicone resin may be used as the binder.

The surface of the metal wire may be coated with a heat-dissipative coating film having heat dissipation capacity if required to rapidly release the heat conducted inside the fin 11 to the outside.
The heat-dissipative coating film may be formed of coating material containing various kinds of pigment having a thermal radiation effect. As the pigment, there have been carbon black, alumina, zirconia, titania, silica, zircon, magnesia, yttria (Y₂O₃), cordierite (2MgO · 2Al₂O₃ · 5SiO₂), and aluminum titanate (Al₂O₃·TiO₂). There may be used either or a combination of these materials as the coating material. The amount of the pigment in the coating material may be arbitrarily determined in accordance with the desired thermal emissivity, but in general, it is preferable to determine 10% to 90% by weight of pigment relative to dry mass of the coating material. It is desirable to use, as a binder for the coating material, materials hard to deteriorate by heat such as acrylate resin, silicone resin, urethane resin, polyester resin and fluorocarbon polymer.
It is desirable to form the heat-dissipative coating film having a thickness of 1 to 50 µm of on the metal wire. In case of less than 1 µm in thickness of the coating film, the thermal radiation effect of the metal wire is reduced disadvantageously.

The diameter of the fin 11 (width of the flat surface 111) is not particularly limited and can be arbitrarily determined in accordance with the heat dissipation performance as required. The surface area becomes large with increasing the diameter of the fin, thus to improve the heat dissipation performance. To be more specific, it is suitable to determine the diameter of a few millimeters to a few centimeters though depending on the use of the heat sink produced according to the invention.

The aforementioned fins 11 are arranged along the grooves 100 in the base plate 10. The fins can be secured on the base plate 10 by any kind of fixing means as long as the thermal conductivity is not diminished. The fins can be secured by soldering, for example. The fin 11 of the metal wire having a circular cross section forms a gap between itself and the groove 100 having a rectangular cross section. By melting and pouring solder into the gap between the fin and the groove, the molten solder is spread along the surface of the fin 11 by the capillary phenomenon, consequently to firmly secure the fin and facilitate heat transfer from the base plate 10 to the fin 11.

As another fixing method, there may be used a thermal conductive adhesive that is a compound made by mixing metal powder such as gold, silver and nickel or powder of alumina, alumina nitride, silicon nitride or carbon with a binder of epoxy resin, silicone resin, acrylate resin or urethane resin.
There may be used the other measures for securing the fin by using the base plate 10 in a corrugated shape having concaves for fitting the fin 11 and then subjecting the entire base plate to mechanical swaging to steadily pinch the fin 11 in the concaves.

Although the fin 11 is secured in the groove 100 of the base plate 10 in the aforesaid embodiment (1), the groove has not necessarily to be formed, and alternatively, it is only necessary to fix the fin on the flat base plate directly or through a thermal conductive layer between the fin and the base plate.

Also, the embodiment (1) above is illustrated as having the fins 11 upstanding vertically from the grooves 100 in the base plate 10, but the heat sink of the invention should not be understood as being limited to this embodiment. The fins 11 may be formed directly on the flat base plate perpendicular or aslant to the base plate 10. For instance, in a case of mounting a cooling fan on the heat sink, the angle and arrangement of fins 10 can be arbitrarily determined in consideration of the blowing direction of the cooling fan so as to obtain maximum cooling effect.

In the embodiment (1) above, the metal wire coil is flattened by squashing, but is not limited to the flattened shape. That is, the metal wire coil may be formed into any shape such as a shape particularly curved at the longitudinal front ends of the coil elements 11a and 11b (e.g. a crescentic shape) or an irregular shape having polygonal end surfaces.

It is desirable to mount the aforementioned heat sink 1 on a semiconductor device through a layer of thermal conductive adhesive agent so as not to prevent transmission of heat from the semiconductor to the heat sink 1.

Next, the second embodiment (2) of the present invention will be described. As shown in FIG 3, the fin 11 is made by winding metal wires 12 and 13 to form consecutive coil elements and flattening the entire coil elements. The coil elements 11a and 11b are aligned in flat as a whole and intersect with one another with displacement in the transversal and longitudinal directions so as to form air gaps 112 and contact parts 113. That is, the displacement of the coil elements 11a and 11b form a number of air gaps 112 (112a, 112b, ..., 112n) and a number of contact parts 113 (113a, 113b, ..., 113n). The flat metal wires 12 and 13 bring the respective coil elements into mutual contact with one another to increase the effective contact area of the contact parts 113.

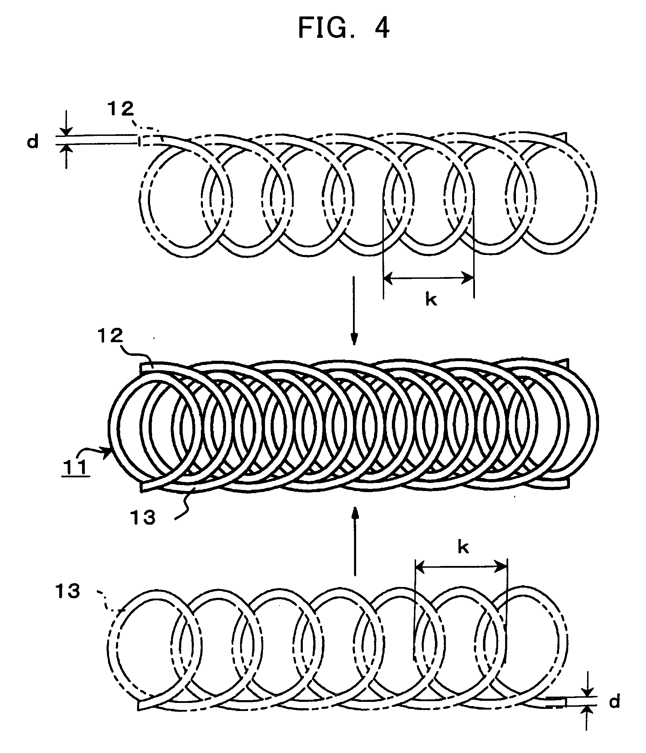

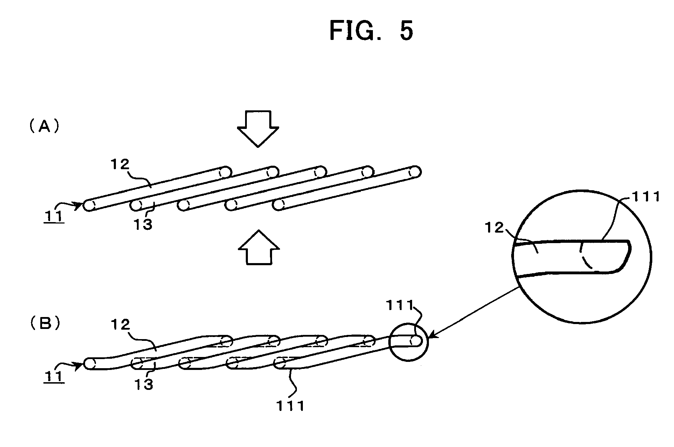

To be more precise, the fin 11 is formed by combining the left handed metal wire coil 12 and the right-handed metal wire coil 13 as shown in FIG 4 and flattening the combined wire coils 12 and 13 by flatting or rolling as shown in FIG 5. When rolling the metal coils under pressure, the strip-like central parts of the wire coils 12 and 13 are bent inwardly (inner side of the overlaid metal wires), and the outer surfaces of the overlaid metal wires are crushed flatly to form flat surface 111 at the central parts. Simultaneously, the central parts of the metal wires 12 and 13 protruding outward are bent inwardly to get thinner, resultantly to form convexo-concave surfaces of the metal wires having intertwined end parts 11c and 11d.

The fin 11 thus formed has the coil elements 11a of the metal wire 12 and the coil elements 11b of the metal wire 13, which are arranged close to and in mutual contact with the adjoining ones, while mutually displacing the coil elements, consequently to form the air gaps 112 and contact parts 113. That is, the coil elements 11a and 11b are displaced by the length m of displacement in the transversal direction and the length n of displacement in the longitudinal direction. It is preferable that the length m of displacement in the transversal direction is 0.5 to 2 times the diameter d of the metal wire 12 or 13. In the case where the length m of the displacement in the transversal direction is in excess of 2 times the diameter d of the metal wire 12 or 13, the metal wires at the end parts 11c and 11d of the fin 11 may possibly be decreased in density. Meanwhile, in the case where the length m of the displacement in the transversal direction is less than 0.5 times the diameter d of the metal wire 12 or 13, the coil elements of the metal wire overlap sizably with one another, resulting in degradation in formability when flattening the metal wire coils by rolling or other flatting method. Further, it is preferable that the length n of displacement in the longitudinal direction is 0.3 to 0.7 times the diameter k in the longitudinal direction of the coil element 11a or 11b.

Since the fin 1 has the combined metal wire coils 12 and 13 wound in the opposite directions, the contact parts 113 of the metal wires 12 and 13 are densely formed, consequently to improve the thermal conductivity and heat dissipation performance of the heat sink. Furthermore, closely intertwining of the right-handed and left-handed metal wires 12 and 13 makes the fin 11 stable, thus to prevent the coils from going slack in continuously rolling the coils.

The respective coil elements 11a and 11b should be conjugated inseparably at the contact parts 113 by a joining method such as soldering, solder plating, flash butt welding, or vibration welding, or an adhesive joining method using adhesive agent or agglutinant, so that appropriate thermal coupling can be formed to decrease thermal transfer resistance. Thus, the contact parts 113 are steadily fixed to bring the coil elements 11a and 11b into close contact with one another, thus improving the mechanical stability of the entire fin 11 and the thermal conductivity of the heat sink through the contact parts 113.

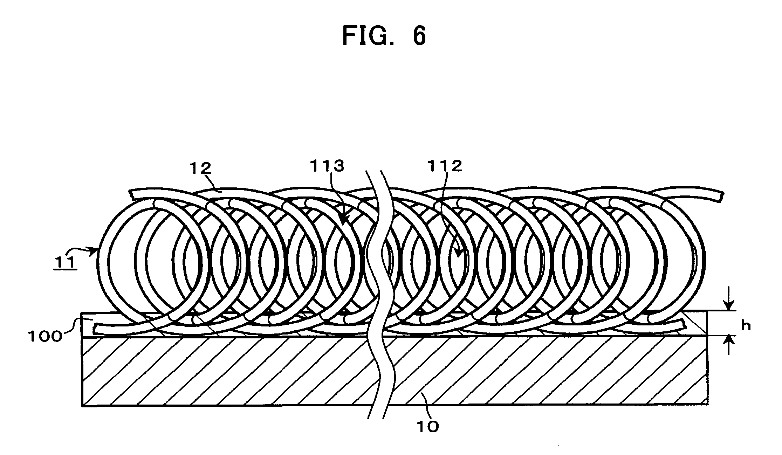

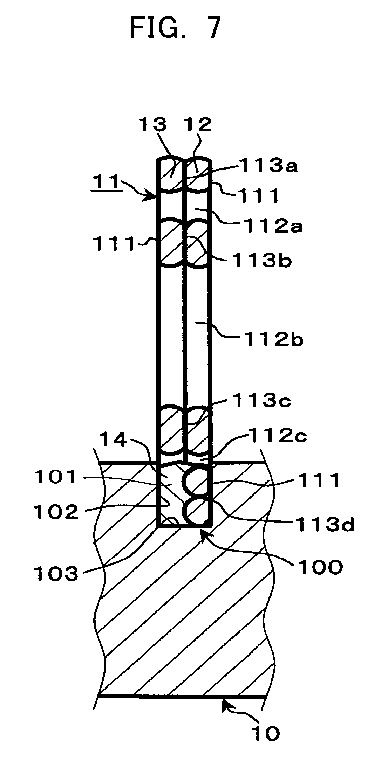

Similarly to the embodiment (1) above, the aforementioned fins 11 are arranged along the grooves 100 in the base plate 10 as shown in FIG 1 and secured on the base plate 10. FIG 6 and FIG 7 are enlarged sectional views of the heat sink taken in the longitudinal direction (along line A-A in FIG 1) and in the transverse direction (along line B-B in FIG 1) according to the second embodiment (2) of the invention. The fins can be thermally secured on the base plate 10 by a bonding or joining method or any other fixing method as long as the thermal conductivity is not diminished. For example, the fin 11 can be joined with the base plate by soldering as shown in FIGS. 6 and 7. Although there is formed gaps between the metal wires of a round-shaped cross section of the fin 11 and the groove 100 of a rectangular cross section, the gaps 101 are filled with molten solder 14 spread throughout the groove 100 by the capillary phenomenon, consequently to secure the fins on the base plate and facilitate heat transfer from the base plate 10 to the fins 11. Specifically, the flat metal wires are in close contact with the fin 11 and the sides 102 of the groove 100 with wide contact areas.

It is preferable that the depth h of the groove is substantially equal to the length in the width direction of the end part 11d of the metal wire, at which the coil elements are densely overlapped, as shown in FIG 6. As a result, the effective contact area between the fin 11 and the sides of the groove 100 is increased. In a case where the end part 11d protrudes out of the groove 100, the fin 11 and the base plate 10 may not be joined reliably. Meanwhile, in a case where the end parts 11c are placed inside the groove 100 on the side of the central part 11e, the air gaps 112 for accommodating the flowing air or the like are placed in the groove 100, thus to deteriorate the heat dissipation performance.

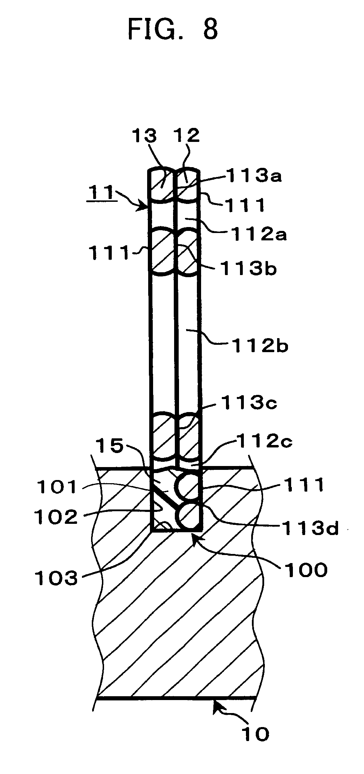

As the other joining method, a thermal conductive adhesive agent 15 may be used as shown in FIG 8. As the thermal conductive adhesive agent 15, there may be enumerated a compound made by mixing metal powder such as gold, silver and nickel or powder of alumina, alumina nitride, silicon nitride or carbon with a binder of epoxy resin, silicone resin, acrylate resin or urethane resin.

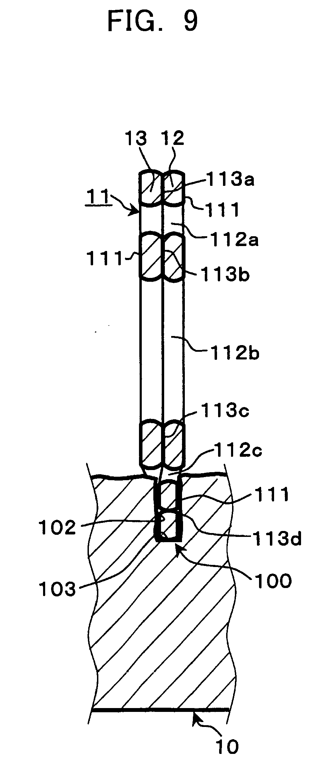

As the other measures for securing the fin 11 on the base plate, there may be used the base plate 10 formed in a corrugated shape having concaves for fitting the fin 11 as shown in FIG 9, so as to subject the entire base plate to mechanical swaging for steadily pinching the fin 11 in the concaves.

In the embodiment (2), the fin 11 is formed by winding metal wire into a coil shape having coil elements 11a and 11b, which are aligned with displacement so as to form air gaps 112 and contact parts 113, so that the heat is promptly transferred to the entire fins 11 through the contact parts 113. Since the fins are formed of the metal wire coils 12 and 13, the fins has the total surface area larger than the flat fins as noted above, consequently to obtain excellent heat dissipation performance. Specifically, since the total surface area of the metal wires 12 and 13 is large, the air passages defined by the air gaps 112 bring about an effect of ventilation in the fins, consequently to promptly release the heat outside.

Although the fin 11 is formed of two metal wire coils 12 and 13 wound in the opposite directions in the embodiment (2), the number of the wire coils is not be limited to two, three or more metal wire coils may be used for form the fin 11.

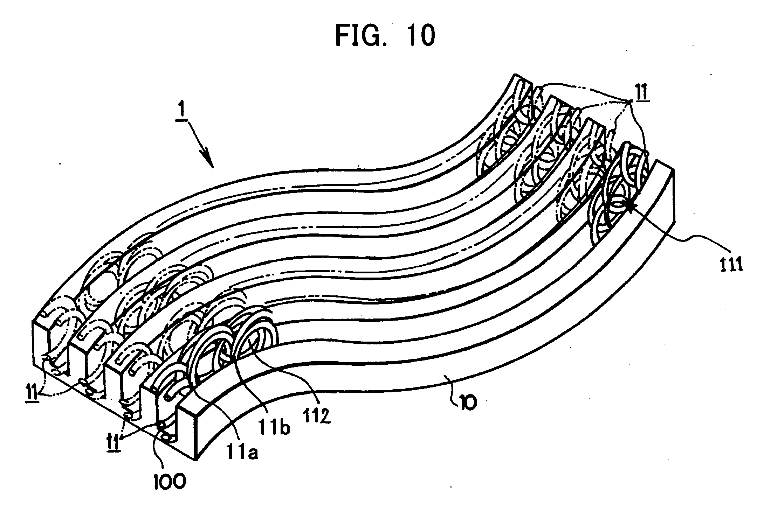

Next, the second embodiment (3) will be described with reference to FIG 10. The heat sink 1 shown in FIG. 10 comprises the base plate 10 with grooves 100 along which the fins 11 are arranged, similarly to the embodiment shown in FIG 1.

The base plate 10 in the embodiment (3) is curved or corrugated with the curved grooves 100. The fin 11 having good flexibility in the direction perpendicular to the flat surface 111 can easily be fitted in the curved groove 100. Thus, a sequence of heat sinks having the flexible fins can suitably be mounted on, for example, a plurality of semiconductor devices placed separately, but not only a single semiconductor device.

The material and structure other than as described above are equivalent to those of the aforementioned embodiment (1). The fin 11 having excellent flexibility in this embodiment of the invention is not limited only to the use for the corrugated base plate 10, but it is applicable suitably to any arrangement of base plates such as concentrically arranged base plates or a spiral-shaped base plate.

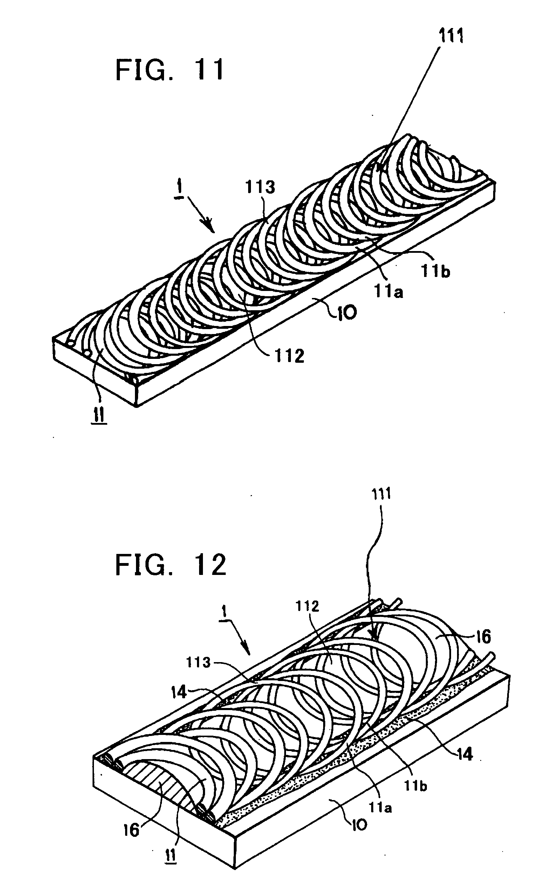

Next, the fourth embodiment (4) of the invention will be described with reference to FIG 4. The heat sink 1 of FIG 11 has the fins 11 of the metal wire coil formed of the coil elements 11a and 11b made by densely winding a flat metal wire. The fins are arranged with the flat surfaces 111 parallel to the heat conductive base plate 10.

Since the effective surface area of the heat sink can also be made large due to the metal wire coils in the embodiment (4), excellent heat dissipation performance can be obtained. Compared with the embodiment of FIG. 1, the entire heat sink can be made thin suitably for a restricted space. The fixation of the fins 11 on the base plate 10 can be fulfilled by an appropriate fixing method such as soldering.

FIG, 12 illustrates the fifth embodiment (5) of the invention. The heat sink 1 of FIG 12 has the fins 11 of the metal wire coil formed of the coil elements 11a and 11b made by densely winding a flat metal wire, which fins are arranged with the flat surfaces 111 parallel to the heat conductive base plate 10, similarly to that in the aforementioned embodiment (4).

The fin 11 in the embodiment (5) is curved in the width direction to form void spaces to be filled with ferrite powder 14. Thus, the heat sink can effectively release the heat and absorb electromagnetic wave with the ferrite powder 14, consequently to cope with both the problems related to heat and electromagnetic wave produced by recent semiconductor devices, which have made remarkable progress in signal processing speed.

The ferrite powder 14 may be mixed with carbon powder such as graphite and/or metal powder.

The heat sinks in the aforementioned embodiments (1) to (5) essentially comprises the base plate 10 securing the fins 11, but the base plate 10 may be omitted if needed.

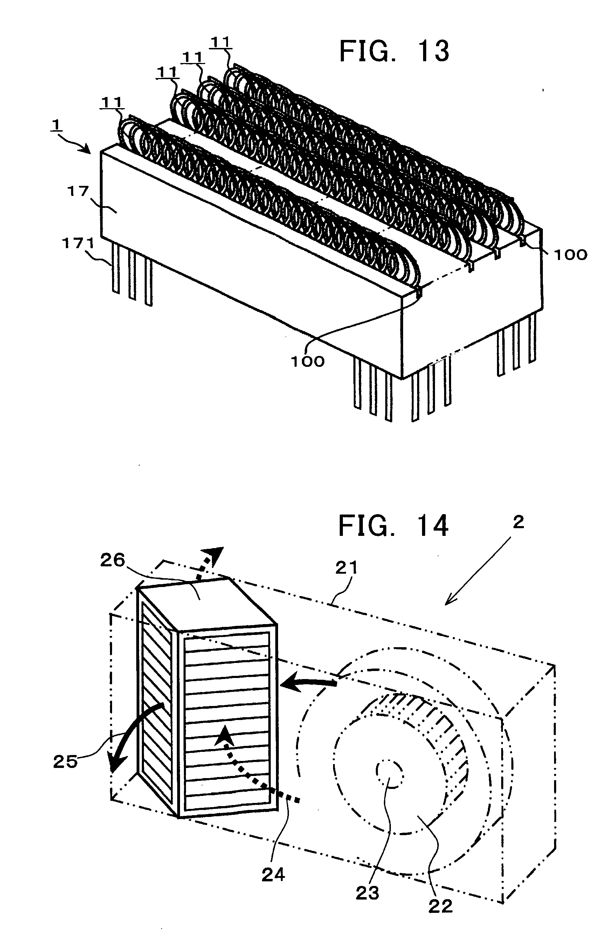

Further, as shown in FIG 13 as an altered form of the heat sink of the invention, the fins 11 made of the metal wire coils may be attached directly to one surface of the semiconductor device 17 to be cooled. In the cooling surface of the semiconductor device 17, there are formed grooves 100 into which the fins 11 are fitted in the standing state. It is desirable to reliably secure the fins 11 in the grooves 100 by an appropriate fixing method such as adhering with a high heat conductive adhesive agent, soldering, welding or mechanical swaging.

Other securing methods than as above may be employed for fixedly standing the fins 11 in the grooves 100 formed in the semiconductor device 17. That is, the fins 11 may be directly fixed on or adhered to the semiconductor device without forming the grooves. The fin may be arranged with the flat surface parallel to the surface to be cooled. A high-resistance material such as aluminum nitride may be used as an addition agent for the thermal conductive adhesive agent if the fin 11 is required to be isolated from the surface to be cooled of the semiconductor device for the use other than for the purpose of securing the fin 11.

Further, the fins 11 may be united with an adhesive sheet formed of a base film, an agglutinant layer and a release paper, which is removed in use, to form a sheet-like (strip-shaped) heat releasing fins. The fin is fixed on the base film with the adhesive agent. This radiating fin can easily be attached to an object to be cooled only by removing the release paper from the fin. The thermal conductivity of the base film and/or agglutinant layer can preferably be enhanced by being made of metal or containing an additive agent such as aluminum nitride.

In the heat sink in the aforementioned embodiments (1) to (5), the fin 11 made of the metal wire coils 12 and 13 is not limited to the circular shape as noted above, but may be formed in a triangular, quadrangular or polygon shape, an elliptical shape, a star shape or any other shapes.

As motioned above, the heat sink is used chiefly for the purpose of releasing the heat produced by the semiconductor element such as a CPU in conjunction with a cooling fan, but should not be understood as being limited to this application. The heat sink of the invention can be appropriately used for various applications in devices to be cooled. Particularly, the heat sink of the invention, which can be made effectively at a low cost, is advantageous for the use in an object having a relatively large area.

FIG 14 shows an application example used in a heat exchange element of an air-conditioning ventilation fan. As shown in FIG 14, the air-conditioning ventilation fan 2 comprises a box-like housing 21, an intake fan 22, an exhaust fan (now shown), and a motor 23 for driving the ventilation fan. There are formed an air intake passage 24 and an air exhaust passage 25 so as to intersect with each other in the heat exchange element when rotating the intake and exhaust fans.

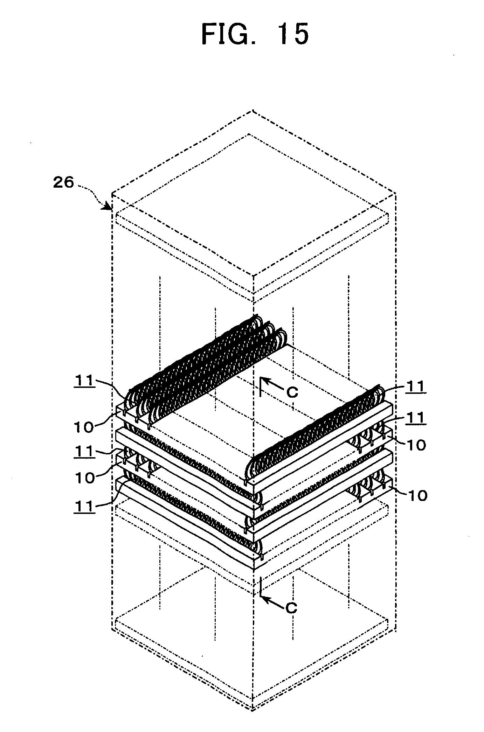

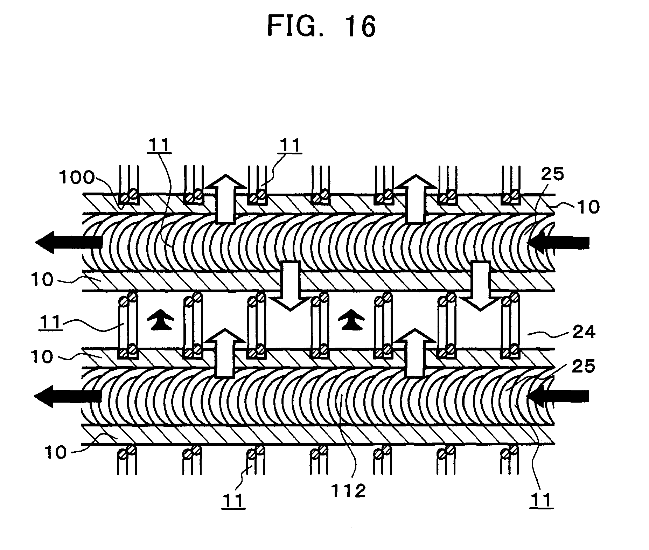

As shown in FIG 15, the air intake passages 24 and air exhaust passages 25 are formed alternately in the heat exchange element by partitioning the interior of the heat exchange element with the base plates 10 having the fins 11.
Thus, heat exchange is efficiently performed as the air having heat rapidly flows from the air exhaust passage 25 to the air intake passage 24 as shown in FIG 16. The air flows through these passages without interruption due to the air gaps 112 in the fins 11. The heat sink of the invention has higher heat exchanging efficiency than a conventional heat exchange element generally formed by piling corrugated boards in layers.

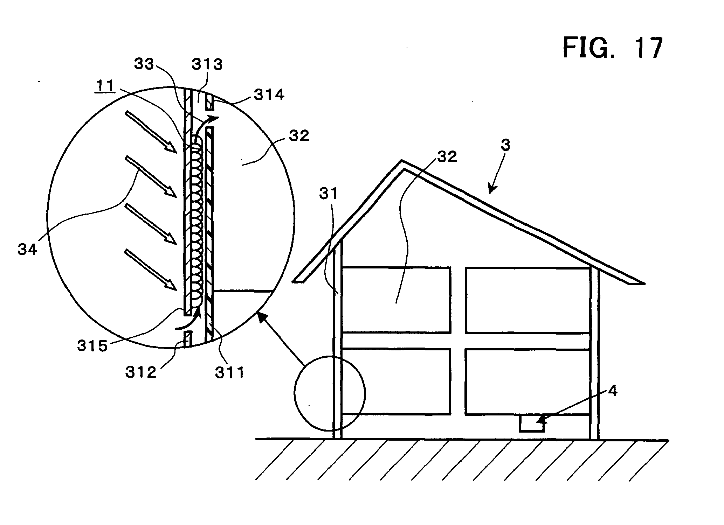

Next, an example of attaching the heat sink of the invention to a wall of a room will be described with reference to FIG. 17. As shown in FIG. 17, the wall 31 of a building 3 is a double-layered structure formed of an inner wall 311 facing inward in the room 32 and an outer wall 312 facing outward. There is formed a space 313 between these walls. The inner wall 311 and outer wall 312 each have air holes 314 and 315 through which the inner and outer spaces are communicated with each other. Within the space 313, the fins 11 are attached to the inner surface of the outer wall 312. In the embodiment shown in FIG 17, the outer wall 312 serves as the heat conductive base plate defined in the invention, but a separate base plate may be placed onto the outer wall so as to attach the fins to the separate base plate. In this case, it is desirable to form the inner wall 311 of thermal insulating material.

In the structure shown in FIG 17, the air 33 is introduced from the outside to the inside of the room 32 through the space 313 and the air holes 314 and 315. At this time, the heat energy of sunlight 33 is transferred to the fins 11 and diffused inside the space 313, consequently to warm up the air 33 for heating the room. In passing, there has been well known a technique of forming a wall space between inner and outer walls of a room wall and introducing the air in the wall space into the room through air gaps formed in the room wall, but a natural heating system using thermal conductive fins for transferring the heat of sunlight has never been so far actualized. Hence, the present invention has novelty.

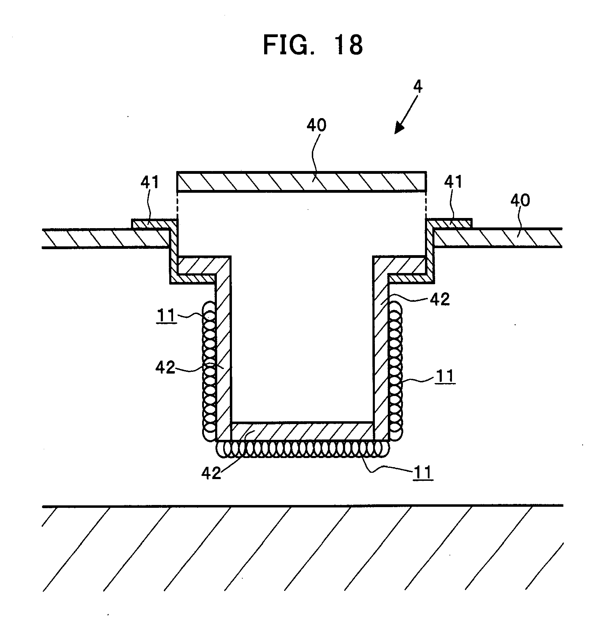

Next, there will be disclosed an example of the heat sink according to the invention applicable to the use in an underfloor storage system. FIG 18 shows a cross section of an underfloor storage portion 4. A storage space of this system is made by forming an opening 401 in a floor 42 and assembling wall members 42 into a box through the opening 401. On the outside of one of the wall members 42, the fins 11 are disposed.

According to the structure above, heat in the storage space is rapidly dispersed in the outside of the underfloor storage system, consequently to prevent the heat from stagnating under floor. The wall members 42 in FIG 18 serve as the heat conductive base plate, but a separate base plate may be placed onto the outside of the wall member so as to attach the fins to the separate base plate.

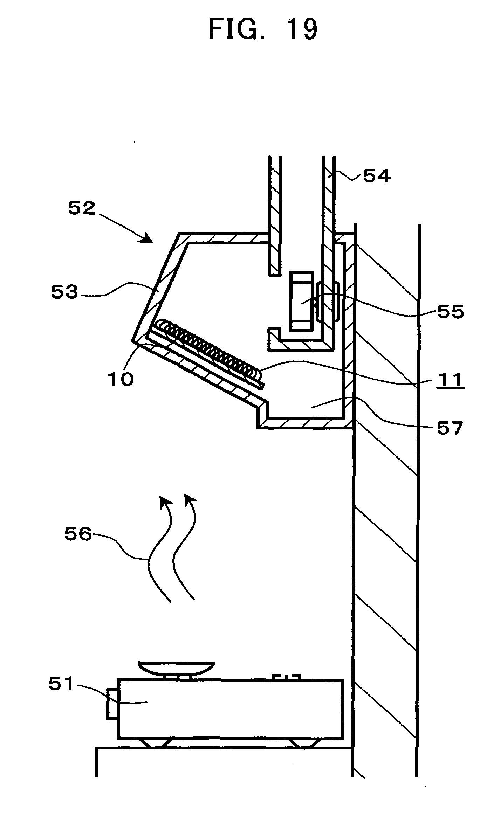

FIG 19 shows an embodiment in which the heat sink of the invention is provided on ventilation equipment 52 above a gas range 51. The ventilation equipment 52 comprises a hood body 53 and an exhaust duct 54 accommodating an exhaust fan 55 so as to discharge air containing oil mist or vapor 56 rising from the gas range 51 to the exterior through the exhaust duct 54. The heat sink comprising the base plate 10 and fins 11 is mounted on inside the hood body 53. A filter generally attached to the hood body 53 is not illustrated for the sake of simplicity.

In this illustrated embodiment, the oil mist or vapor 56 becomes liquid when reaching the fins 11 by providing rapid heat removal from the oil mist or vapor. The liquefied oil content flows into a pocket 57 to be collectable. The base plate 10 may be provided with through holes or grooves for conducting the collected oil downwardly or facilitating flowing of the collected oil into the pocket 57.

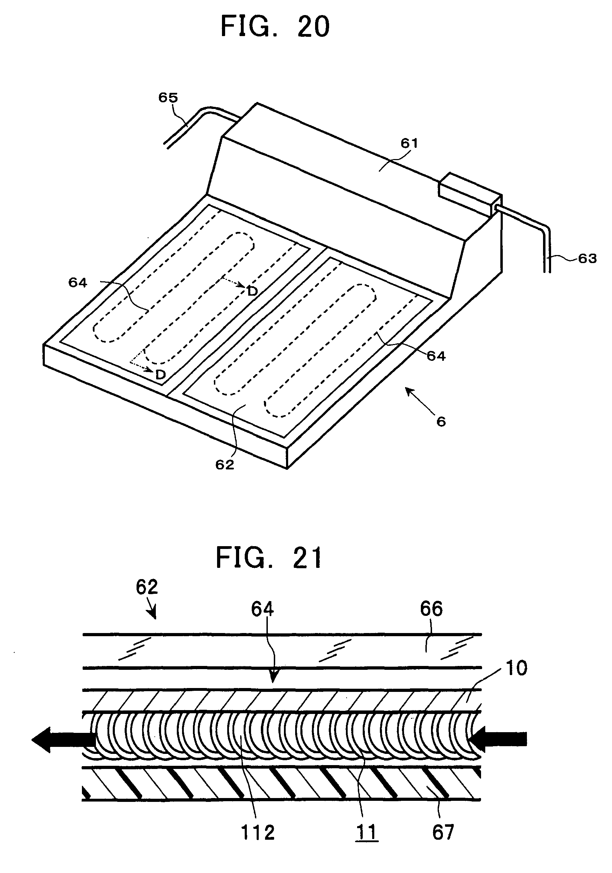

FIG. 20 and FIG 21 show an example of use in a solar water heater. The solar water heater 6 generally comprises a hot water reservoir 61, and a heat collecting unit 62 for heating water fed to the hot water reservoir 61 through a water supply pipe 63 when flowing through a pipe 64 arranged inside the heat collecting unit 62. The hot water thus heated is circulated and stored in the hot water reservoir 61, and then, supplied to a bath or used for other purposes through an outflow pipe 65.

The heat collecting unit 62 is provided on its upper side with a transparent member 66 such as glass so as to allow the sunlight to pass therethrough. Inside the heat collecting unit, there are disposed the heat conductive base plate 10, fins 11 secured on the base plate 10, and a heat insulating material 67. The fins 11 serve as pipes for conducting water, so that the water is movable through the air gaps 112 formed in the fins 11.

According to the aforementioned structure, the heat energy of the sunlight is rapidly transferred from the base plate to the water through the fins 11, consequently to produce hot water efficiently.
The base plate 10 in the embodiment of FIG 21 is formed in a rectilinear shape, but may be formed in a corrugated shape. The corrugated base plate will cause turbulent flow of water, thus to effectively transfer the heat.

The aforementioned application examples of the heat sink according to the invention should not be understood as being limitative. The heat sink of the invention can be used for versatile applications as a heat releasing element and a heat exchanging element.

### INDUSTRIAL APPLICABILITY

The heat sink according to the invention may have applicability not only for cooling semiconductor devices, but also to a heat transfer element in a ventilation fan or the like.

## Claims

1. A heat sink comprising fins formed by winding metal wire into a coil shape having coil elements aligned in flat with displacement so as to form air gaps and contact parts, and a thermal conductive base plate retaining said fins.

2. The heat sink set forth in claim 1, featured by thermal coupling between the contact parts of said coil.

3. The heat sink set forth in claim 1 or claim 2, wherein said metal wire coil is formed of combinations of right-handed and left-handed coils displaced mutually.

4. The heat sink set forth in claim 1 or claim 2, wherein said fins are disposed relative to said base plate in a standing manner.

5. The heat sink set forth in claim 3, wherein said fins are disposed relative to said base plate in a standing manner.

6. The heat sink set forth in claim 4, wherein said fins are disposed in a groove formed in said base plate in a standing manner.

7. The heat sink set forth in claim 5, wherein said fins are disposed in a groove formed in said base plate in a standing manner.

8. The heat sink set forth in claim 6, wherein said fins are thermally coupled to said groove in said base plate.

9. The heat sink set forth in claim 7, wherein said fins are thermally coupled to said groove in said base plate.

10. The heat sink set forth in claim 1 or claim 2, wherein the flat surfaces of said fins are arranged parallel to said thermal conductive base plate.

11. The heat sink set forth in claim 3, wherein the flat surfaces of said fins are arranged parallel to said thermal conductive base plate.

12. The heat sink set forth in claim 10, wherein void spaces are formed between said fins and said base plate and filled with ferrite powder.

13. The heat sink set forth in claim 11, wherein void spaces are formed between said fins and said base plate and filled with ferrite powder.

14. A heat sink comprising fins of metal wire coil formed of coil elements made by densely winding a flat metal wire.

15. A sheet-like heat sink comprising a base film with agglutinant, and fins of metal wire coil formed of coil elements made by densely winding a flat metal wire on said base film.

16. The heat sink set forth in claim 14 or claim 15, wherein said metal wire coil is formed of combinations of right-handed and left-handed coils displaced mutually.

17. The heat sink set forth in any of claim 1, 2, 14 and 15, wherein a coating film containing ferrite is formed on the surface of said metal wire.

18. The heat sink set forth in any of claim 1, 2, 14 and 15, wherein said metal wire is made of aluminum or aluminum alloy and subjected to surface treatment with anodic oxide film.

19. The heat sink set forth in any of claim 1, 2, 14 and 15, wherein said metal wire is made of anticorrosion metal.

20. The heat sink set forth in any of claim 1, 2, 14 and 15, wherein a heat-dissipative coating film having heat dissipation capacity is formed on the surface of said metal wire.
